# EUROPEAN PATENT APPLICATION

(11) **EP 0 971 572 A1**
(43) Date of publication of application: **12.01.2000**
(21) Application number: 98305486.7
(22) Date of filing: 10.07.1998
(51) Int. Cl.: H05K 7/18, F16B 5/06

(54) **An assembly comprising two components and a mechanism for fastening them together**

(71) Applicant: Reddicliffe, Edward A., Lymington, Hants SO41 8PS (GB)
(72) Inventor: Reddicliffe, Edward A., Lymington, Hants SO41 8PS (GB)
(74) Representative: Jackson, Peter Arthur

(57) **Abstract**

An assembly comprising two components (1,4) each having a hole (3,6,8), and a fastening mechanism comprising a hook (2) on one component by which one component is hooked on to the other such that the two holes are aligned. A quick fit fastener (7) is inserted into the aligned holes to secure the components against relative movement in a direction which could cause the hook to be disengaged from its hooked position.

## Description

The present invention relates to an assembly comprising two components and a mechanism for fastening them together. The invention has particular applications in the field of cabinets for electronic equipment. Such cabinets are often installed in large numbers so that the time it takes to assemble an individual cabinet is critical. Even a small time saving in the fitting of a component can result in a significant reduction in the overall installation time if there are several such components in a single cabinet, and many cabinets in an installation.

Nuts and bolts which are traditionally used are reliable but very time consuming. Also, access through all four faces of the cabinet is desirable to avoid severely extended fitting times. Further, nuts, bolts, screwdrivers and spanners can fall into active electronic equipment to cause damage or even short circuiting.

A recent practice has been the use of quick fit fasteners to hold two components together. A quick fit fastener is defined as a fastener which can be manually pushed into aligned holes in adjacent components so that a portion of the fastener projects beyond the holes and spreads to cooperate with the head of the fastener to hold the two components together. Although these fasteners are quick to fit, they tend to pop open under very light loads or when the component is knocked, either due to structural failure of the plastic or due to premature release of the anchoring device. For this reason their use is severely limited in electronics cabinets.

According to the present invention, assembly comprises two components each having a hole, and a fastening mechanism for joining the two components, the fastening mechanism comprising a hook on one component by which the one component is hooked onto the other, in a configuration in which the two holes are aligned, and a quick fit fastener inserted into the aligned holes to secure the components against relative movement in a direction which could cause the hook to be disengaged from its hooked position.

The combination of the hook and the quick fit fastener allows the hook to take the majority of the loading which, in the prior art, would tend to pull the fastener apart or shear it. In the present invention, the fastener is simply a locking device to prevent a component from accidentally being dislodged, for example, when it is knocked.

The hook still allows extremely rapid joining between the components as it simply needs to be hooked onto the other component before the quick fit fastener is engaged. It can also help with the location of the two holes through which the fastener is inserted. Further, there is no need for tools or components such as nuts and bolts which have to be assembled in situ, so that the number of loose parts is minimised.

The hook may be separate from or attachable to one of the components. However, it is preferable for the hook to be integral with one of the components. For example, if the component is made from a sheet material, the hook may be a punched lug.

Generally speaking, for a component which is loaded vertically, the hook will face downwardly and engage with an upwardly facing edge on the other component, or will face upwardly and engage with a downwardly facing edge on the other component. On the other hand, the hook may extend in a non-vertical direction and vertical forces between the two components may be borne by virtue of the width of the hook being substantially the same as the width of a hole into which the hook is hooked, so that the lateral edges of the hook provide a close fit with the lateral edges of the hole.

The quick fit fastener may be of any one known type. For example, the fastener may have a resilient portion which is inwardly deformed as the fastener is pushed through the aligned holes, and springs outwardly once beyond the holes to hold the fastener in place. The resilient member may be resilient fins provided around the body of the first mechanism, or the fastener body may have resiliently deformable legs. An alternative construction is a two part quick-fit fastener, in which a first part is fitted into the aligned holes and a second part retained in the first part is pushed further into the first part such that complementary cam surfaces on the two parts spread the fastener to lock it in place within the aligned holes. With such an arrangement, the two portions may be provided with cooperating screw threads or angled faces under the head similar to a cam face allowing the second part to be screwed out of the first part to release the fastener.

One of the components may, for example, be a bracket such as cable guide, a cantilevered shelf, a cable tray, or an electrical fitting while the other component is the support to which one of the above components is fixed.

The present invention also extends to a method of joining two components, each having a hole and one of which has a hook, the method comprising the steps of hooking one component onto the other so that the two holes are aligned, and pushing a quick fit fastener into the aligned holes to secure the components against relative movement in a direction which would cause the hook to be dislodged from its hooked position.

The samples of assemblies constructed in accordance with the present invention will now be described with reference to the accompanying drawing, in which:
Fig. 1A is a perspective view of a first example before the components are assembled;
Fig. 1B is a perspective view of the same example with the components assembled;
Fig. 2A is a perspective view of a second example before the components are assembled; and
Fig. 2B is a perspective view of the same example with the components assembled.

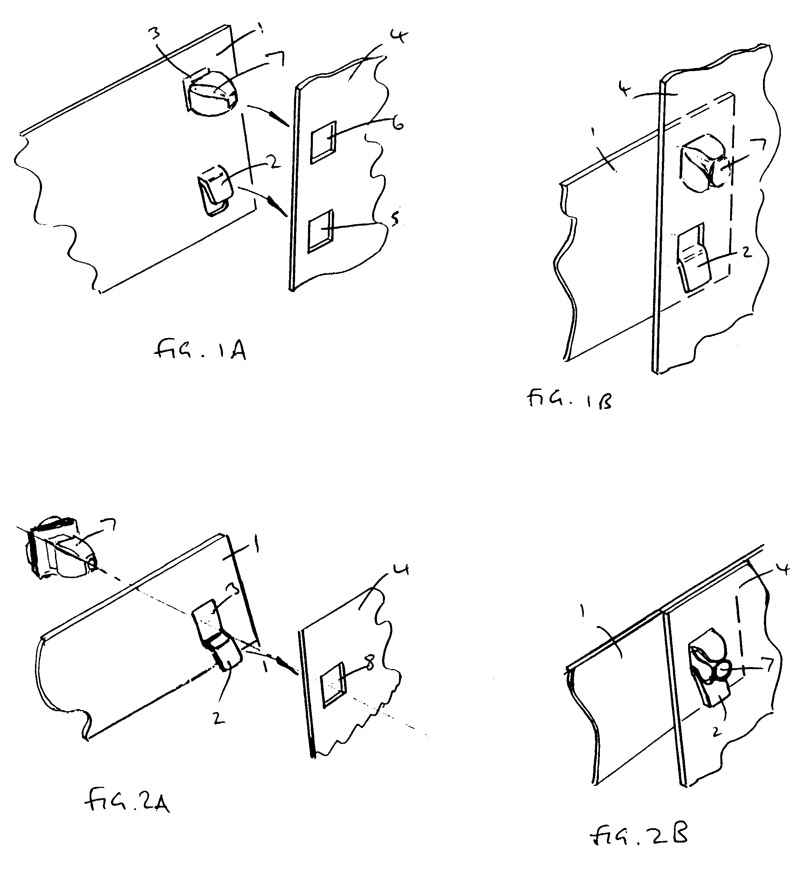

As shown in Figs. 1A and 1B a first component 1 of sheet like construction has a punched lug providing a hook 2, and a hole 3. The second component 4 is provided with a first hole 5 for receiving the hook 2 and a second hole 6. In order to assemble the two components the hook 2 is pushed through the hole 5 and dropped down to engage with the lower edge of the hole 5. In this position the holes 3 and 6 are aligned so that a quick fit fastener 7 can be pushed through these holes to anchor the two components together to prevent the hook from being dislodged from the position shown in Fig. 1B. In Fig. 1A the quick fit fastener is shown already inserted in the hole 3 of the first component 1 prior to assembly. This is an alternative way of assembling the two components.

A second example is shown in Figs. 2A and 2B where similar parts are designated with the same reference numerals as in the previous example. In this example, the hook is formed by being punched and bent through an obtuse angle so as to depend downwardly from the hole 3. This arrangement means that only a single hole 8 is necessary in the second component 4. When the two components are assembled, the hook 2 engages with the lower edge of the hole 8 bringing the hole 3 into alignment with the hole 8 allowing the insertion of a quick fit fastener 7.

## Claims

1. An assembly comprising two components (1,4) each having a hole (3,6,8), and a fastening mechanism for joining the two components, the fastening mechanism comprising a hook (2) on one component by which the one component is hooked onto the other, in a configuration in which the two holes are aligned, and a quick fit fastener (7) inserted into the aligned holes to secure the components against relative movement in a direction which could cause the hook to be disengaged from its hooked position.

2. An assembly according to claim 1, wherein the hook (2) is integral with one of the components.

3. A method of joining two components (1,4), each having a hole (5,6,8) and one of which has a hook (2), the method comprising the steps of hooking one component onto the other so that the two holes are aligned, and pushing a quick fit fastener (7) into the aligned holes to secure the components against relative movement in a direction which would cause the hook to be dislodged from its hooked position.
